# EUROPEAN PATENT APPLICATION

(11) **EP 3 879 634 A1**
(43) Date of publication of application: **15.09.2021**
(21) Application number: 20382179.8
(22) Date of filing: 12.03.2020
(51) Int. Cl.: H01R 12/73, H01R 12/88, H05K 3/36, H01R 24/00

(54) **CONNECTION ASSEMBLY FOR STACKED PRINTED CIRCUIT BOARDS**

(71) Applicant: Grupo Antolin-Ingenieria, S.A., 09007 Burgos (ES)
(72) Inventor: CUCHE, Remy, 25021 Besançon (FR)
(74) Representative: Capitán García, Maria Nuria

(57) **Abstract**

Connection assembly for electrically connecting two or more stacked printed circuit boards. It comprises a first printed circuit board and a second printed circuit board and an electrical connector. The electrical connector having a fixing device and at least a first metal plate to electrically connect the first printed circuit board to the second printed circuit board by rotating the electrical connector. The electrical connector being removable in order to allow a customizable configuration of the stacked printed circuit boards adaptable to the different functionalities required depending on the particular final application to which the circuit is directed, and according to a quick and accurate way.

## Description

### TECHNICAL FIELD OF THE INVENTION

The present invention relates to a connection assembly for stacked printed circuit boards. Particularly, it relates to a connection assembly for electrically connecting two or more circuit boards.

### BACKGROUND OF THE INVENTION

It is known to construct electronic systems which comprise printed circuit boards (PCBs) stacked on one another and electrically connected to one another.

The stacking of PCBs has, in particular, the advantages of improving the performance of the electrical connections and reducing the size. The latter is an issue when the available space is limited.

When two PCBs are stacked, they have to be accurately aligned in order to ensure the electrical connection between them.

For that, it is common to provide a frame having guides where the PCBs are successively stacked.

Once, the PCBs are stacked, the electrical connection between them is carried out.

An available option to electrically connect two PCBs is soldering.

In this way, connection holes are provided in each of the PCBs in order to insert a connection rod which ends are soldered to each of the PCBs so as to complete the electrical connection between the stacked PCBs as JP2778575B2 discloses.

The main disadvantage of this kind of electrical connection is that it is a non-removable fixation.

In view of the above, the object of the present invention relates to a connection assembly for stacked printed circuit boards comprising an electrical connector being removable in order to allow a customizable configuration of the stacked printed circuit boards adaptable to the different functionalities required depending on the particular final application to which the circuit is directed, and according to a quick and accurate way.

### DESCRIPTION OF THE INVENTION

The present invention is established and characterised in the independent claims, while the dependent claims describe additional characteristics thereof.

Firstly, the particular configuration of the electrical connector makes the connection assembly very simple when it is compared with other connection assemblies using complex electrical connectors such as soldering.

Due to the particular configuration of the electrical connector of the present invention being a removable electrical connection, it is possible to easily and quickly disassemble the stacked PCBs in order to obtain a customizable circuit configuration wherein several different PCBs can be combined depending on the particular final application to which the circuit is directed.

Due to the particular configuration of the electrical connector of the present invention, it can be quickly assembled by inserting it through the aligned connection holes of the PCBs, and then, by rotating said electrical connector, it is possible to quickly change the PCB configuration in order to customize circuit according to the particular final application to which the circuit is directed.

In an optional case in which each of the PCBs comprises several electrical connection holes it is possible to customize the circuit configuration by electrically connecting different electrical tracks of the two particular PCBs. Thus, it is not necessary to provide a different PCB to configure the different circuit, it would suffice the provision of two PCBs wherein particular electrical tracks are activated or deactivated depending on the particular final application to which the circuit is directed. It allows standardizing the PCBs forming the assembly and consequently reducing the cost.

### DESCRIPTION OF THE DRAWINGS

This specification is supplemented with a set of drawings illustrating the preferred embodiment, which are never intended to limit the invention.
Figure 1A shows a cross-sectional view of the section AA represented in Figure 2 corresponding to the connection assembly for stacked printed circuit boards according to a position in which the printed circuits are electrically connected through the electrical connector.
Figure 1B shows the detail D represented in Figure 1A.
Figure 2 shows a plan view of the connection assembly for stacked printed circuit boards wherein the fourth side of the second circuit can be seen, according to a position in which the printed circuits are electrically connected through the electrical connector.
Figure 3 shows a perspective view of the electrical connector wherein the fixing device and the first and second metal plates are mounted.
Figure 4 shows an exploded perspective view of the electrical connector comprising the fixing device and the first and second metal plates.
Figures 5A-5C show three perspective views of the connection assembly for stacked printed circuit boards according to three steps of the assembly process of the printed circuits wherein the second electrical connection hole is shown.
Figure 6 shows a perspective view of the connection assembly for stacked printed circuit boards wherein the first electrical connection hole is shown.

### DETAILED DESCRIPTION OF THE INVENTION

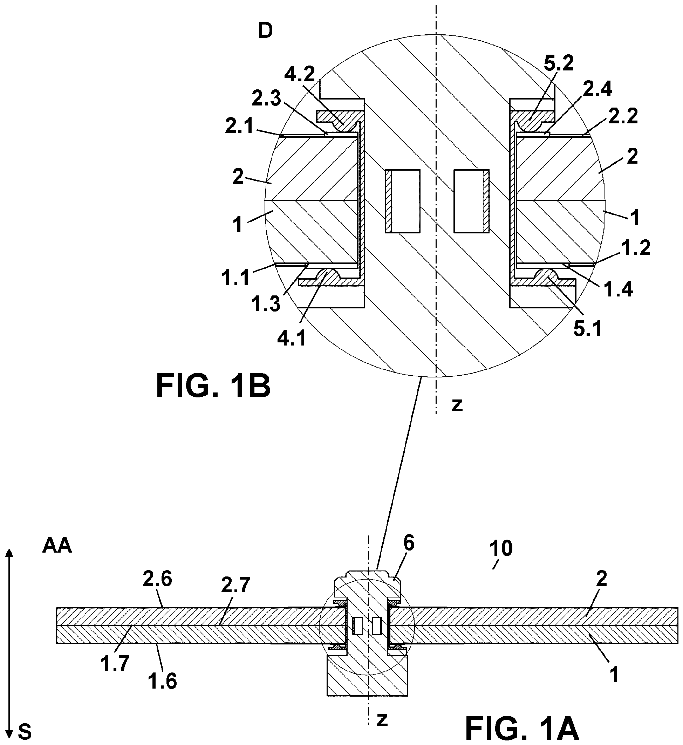

As figure 1A and more particularly the detail D represented in the figure 1B shows, the connection assembly (10) for stacked printed circuit boards according to the present invention comprises mainly a first printed circuit board (1), a second printed circuit board (2), and an electrical connector (6) configured to connect electrically both printed circuit boards (1, 2).

Particularly, the first printed circuit board (1) has a first side (1.6) and a second side (1.7) opposite to the first side (1.6), and a first electrical connection hole (1.5) extended through the first printed circuit board (1) from the first side (1.6) to the second side (1.7).

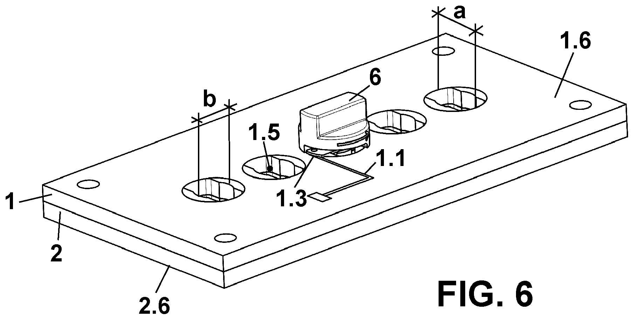

As figure 6 shows, the first electrical connection hole (1.5) is a non-circular hole which comprises a first dimension "a" and a second dimension "b" in the first side (1.6), being the second dimension "b" smaller than the first dimension "a".

Optionally, the first printed circuit board (1) can comprise as many electrical connection holes as necessary as figure 6 shows, wherein four further electrical connection holes have been represented. The further electrical connection holes share the same technical features as the first electrical connection hole (1.5).

The first side (1.6) of the first printed circuit board (1) comprises a first electric track (1.1) and a first electrical contact (1.3) electrically connected to the first electrical track (1.1).

Optionally, it can comprise a third electric track (1.2) and a third electrical contact (1.4) electrically connected to the third electrical track (1.2) .

According to this particular case, either the first electrical contact (1.3) and the third electrical contact (1.4) can be isolated in such a way that the first electrical track (1.1) is independent electrically of the third electrical track (1.2), or the first electrical contact (1.3) and the third electrical contact (1.4) can be electrically connected between them in such a way that the first electrical track (1.1) and the third electrical track (1.2) are electrically connected.

Additionally, the first side (1.6) of the first printed circuit board (1) can comprise as many electrical tracks as necessary.

Particularly, the second printed circuit board (2) has a third side (2.6) and a fourth side (2.7) opposite to the first side (2.6), and a second electrical connection hole (2.5) extended through the second printed circuit board (2) from the third side (2.6) to the fourth side (2.7).

The second electrical connection hole (2.5) is a non-circular hole which comprises a first dimension "c" and a second dimension "d" in the third side (2.5), being the second dimension "d" smaller than the first dimension "c".

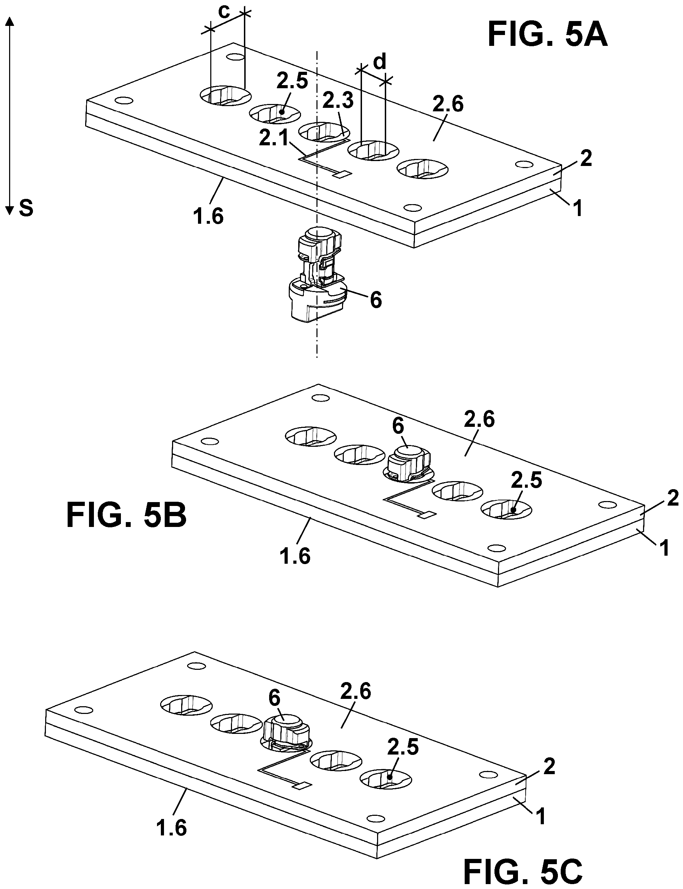

As in the case of the first printed circuit (1) configuration, the second printed circuit board (2) can optionally comprise as many electrical connection holes as necessary as figures 5A-5C show, wherein four further connection holes have been represented. The further electrical connection holes share the same technical features as the second electrical connection hole (2.5).

The third side (2.6) of the second printed circuit board (2) comprises a second electric track (2.1) and a second electrical contact (2.3) electrically connected to the second electrical track (2.1).

Optionally, it can comprise a fourth electric track (2.2) and a fourth electrical contact (2.4) electrically connected to the fourth electric track (2.2) .

According to this particular case, either the second electrical contact (2.3) and the fourth electrical contact (2.4) can be isolated in such a way that the second electrical track (2.1) is electrically independent of the fourth electrical track (2.2), or the second electrical contact (2.3), and the fourth electrical contact (2.4) can be electrically connected between them in such a way that the second electrical track (2.1) and the fourth electrical track (2.2) are electrically connected.

Additionally, the third side (2.6) of the second printed circuit board (2) can comprise as many electrical tracks as necessary.

Both printed circuit boards (1, 2) above described, are configured to adopt a stacked position according to which they are ready to be electrically connected in order to adopt a stacked assembly position in which both printed circuit boards are electrically connected.

According to said stacked position the second side (1.7) of the first printed circuit board (1) faces the fourth side (2.7) of the second printed circuit board (2) defining a stacking direction S, either contacting both printed circuit boards (1, 2) or without contacting between them.

On the other hand, according to said stacked position, the first and the second electrical connection holes (1.5, 2.5) are aligned along the stacking direction S. In the case in which the printed circuit boards (1, 2) comprise further electrical connection holes, they can also be aligned, the corresponding ones to the first printed circuit board (1) with the corresponding ones to the second printed circuit board (2) in order to both printed circuit boards can be electrically connected through all of them.

In order to stack the printed circuit boards (1, 2) a frame (not represented) having guides where the printed circuit boards (1, 2) can be successively stacked can be used. However, the frame is considered an optional component due to the fact that it is not a relevant component according to the problem solved by the present invention.

Although two printed circuit boards (1, 2) have been described, the present invention considers a configuration in which more than two printed circuit boards are stacked and can be electrically connected in such a way that the printed circuit boards need not necessarily be arranged adjacent to each other in order to electrically connect them, it is possible that intermediate printed circuits boards are arranged between the printed circuit boards to be connected provided that the intermediate printed circuits boards are configured to allow passing through then the electrical connector (6).

The electrical connector (6) is the component of the assembly configured to electrically connect the first printed circuit board (1) to the second printed circuit board (2).

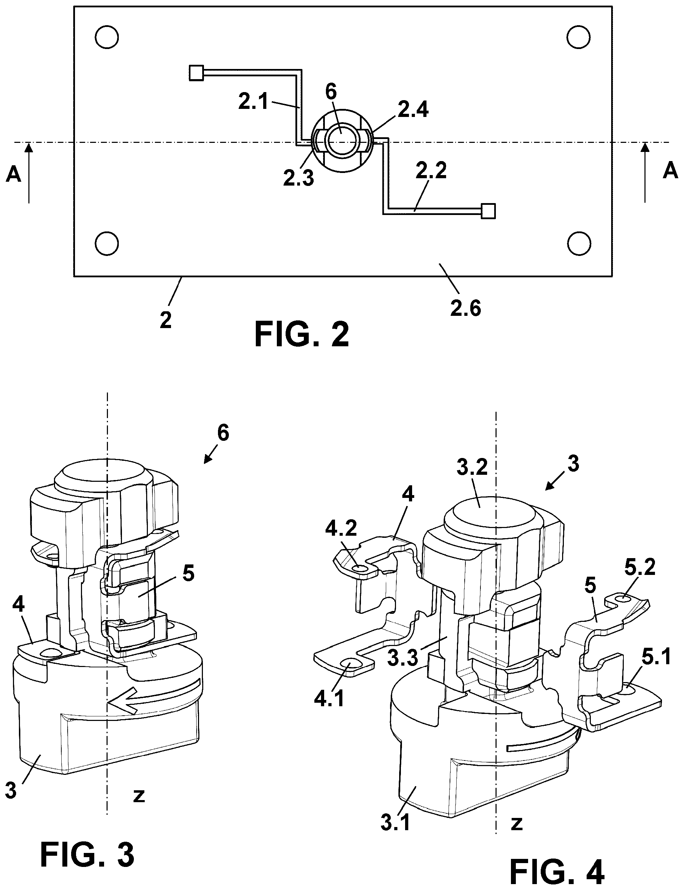

As figures 3 and 4 show, the electrical connector (6) comprises a fixing device (3) and at least a first metal plate (4).

The first metal plate (4) is mounted on the fixing device (3) for example by a crimping process or it can be placed as an insert in the mould wherein the fixing device (3) is moulded for example by plastic injection.

The fixing device (3) comprises a main axle z extended along the stacking direction S, a retention head (3.1) configured to be placed on the first side (1.6) of the first printed circuit board (1) according to the stacked assembly position, and a bearing head (3.2) configured to be placed on the third side (2.6) of the second printed circuit board (2) according to the stacked assembly position, and a rod (3.3) extended in the main axle direction z which connects the retention head (3.1) and the bearing head (3.2).

The bearing head (3.2) can comprise tension ramps which ensure an optimal tension in the stacked assembly position.

The fixing device (3) preferably is made of plastic material such as polyamide (PA), polyoxymethylene (POM), etc.

The first metal plate (4) is configured to electrically connect the first and the second printed circuit boards (1, 2). In order to allow said connection, the first metal plate (4) comprises a first electrical connecting pad (4.1) and a second electrical connecting pad (4.2).

Advantageously, the first electrical connecting pad (4.1) and a second electrical connecting pad (4.2) are elastically deformable in order to ensure the electrical connexion.

As figure 4 shows, the first metal plate (4) can be configured as for example a U-shaped or C-shaped metal sheet. It can comprise a bent metal plate having a central web configured to rest on the rod (3.3) and two flanges at each end of the central web being bent at right angles configured to rest respectively on the retention head (3.1) and on the bearing head (3.2). The first electrical connecting pad (4.1) and a second electrical connecting pad (4.2) being placed at each of the two bent flanges. In addition, the first metal plate (4) can comprise a middle flange bent at a right angle at a middle portion of the metal sheet to connect the first metal plate (4) to the fixing device (3).

The first metal plate (4) can be made of different metal materials such as brass or steel, both characterized by their good elasticity properties. Other metallic materials are also considered by the present invention.

As for example figures 1B, 3 and 4 show, the electrical connector (6) can comprise a second metal plate (5) comprising the same features as the ones described for the first metal plate (4).

The second metal plate (5) is also configured to electrically connect the first and the second printed circuit boards (1, 2).

Particularly, the second metal plate (5) comprises a third electrical connecting pad (5.1) and a fourth electrical connecting pad (5.2).

Additionally, the electrical connector (6) can comprise further metal plates in order to connect different electrical tracks forming part of each printed circuit board (1, 2).

As it has been mentioned above, the electrical connector (6) is configured to be rotated in order to the connection assembly (10) of the present invention adopt the stacked assembly position in which the first and the second electrical tracks (1.1, 2.1) are electrically connected, that is, the position in which the first and the second printed circuits (1, 2) are electrically connected.

As figures 1A, 1B and 5C show, according to said stacked assembly position:
- the first electrical connecting pad (4.1) contacts the first electrical contact (1.3) of the first printed circuit board (1),
- the second electrical connecting pad (4.2) contacts the second electrical contact (2.3) of the second printed circuit board (2).

Optionally, in the case in which the electrical connector (6) comprises a second metal plate (5), additionally in the stacked assembly position:
- the third electrical connecting pad (5.1) contacts the third electrical contact (1.4) of the first printed circuit board (1), and
- the fourth electrical connecting pad (5.2) contacts the fourth electrical contact (2.4) of the second printed circuit board (2).

Figures 5A-5C show in detail the different steps of the assembly process from which the connection assembly (10) changes its arrangement from the stacked position, that is, when the two printed circuit boards (1, 2) are stacked but they are not yet electrically connected as figure 5A shows, to the stacked assembly position, that is, when the two printed circuit boards (1.2) are electrically connected as figure 5C shows.

Particularly, figure 5A shows an arrangement of the connection assembly (10) in which:
- the two printed circuit boards (1, 2) are stacked in such a way that the second side (1.7) of the first printed circuit board (1) faces the fourth side (2.7) of the second printed circuit board (2),
- the first and the second electrical connection holes (1.5, 2.5) are aligned along the stacking direction S, and
- the electrical connector (6) is aligned with the first and the second electrical connection holes (1.5, 2.5), and it is ready to be inserted through said electrical connection holes (1.5, 2.5).

Figure 5B shows an arrangement of the connection assembly (10) in which:
- the electrical connector (6) has been introduced through the electrical connection holes (1.5, 2.5) until the retention head (3.1) butts the area of the first side (1.) surrounding the first electrical connection hole (1.5). In this position, the bearing head (3.2) has passed through both electrical connection holes (1.5, 2.5) and it completely protrudes above the third side (2.6) of the second printed circuit board (2), in such a way there is no any interference which prevents the rotation of the electrical connector (6) in order to stablish the electrical connection.

The bearing head (3.2) is configured to pass through the non-circular electrical connection holes (1.5, 2.5).

Figure 5C shows an arrangement of the connection assembly (10) in which: - the electrical connector (6) has been rotated, normally 90°, in order to complete the electrical connection between the two printed circuit boards (1, 2) due to the electric contacts stablished between the electrical connecting pads (4.1, 4.2, 5.1, 5.2) and the electrical contacts (1.3, 1.4, 2.3, 2.4).

The bearing head (3.2) is configured to be retained against the area of the third side (2.6) surrounding the second electrical connection hole (2.5) once it has been rotated as figure 5C shows.

For the sake of clarity, figures 5A-5C and 6 only show one electrical track (1.1., 2.1) in each printed circuit board (1, 2), however as it has been described above, the printed circuit boards (1, 2) can comprise as many electrical tracks as necessary.

## Claims

1. Connection assembly (10) for stacked printed circuit boards comprising:
- a first printed circuit board (1) having a first side (1.6) comprising a first electric track (1.1) and a first electrical contact (1.3) electrically connected to the first electrical track (1.1), a second side (1.7) opposite to the first side (1.6), and a first electrical connection hole (1.5) extended through the first printed circuit board (1) from the first side (1.6) to the second side (1.7),
- a second printed circuit board (2) having a third side (2.6) comprising a second electric track (2.1) and a second electrical contact (2.3) electrically connected to the second electrical track (2.1), a fourth side (2.7) opposite to the third side (2.6), and a second electrical connection hole (2.5) extended through the second printed circuit board (2) from the third side (2.6) to the fourth side (2.7),
- an electrical connector (6) configured to electrically connect the first electric track (1.1) and the second electric track (2.1) through the first and the second electrical connection holes (1.5, 2.5),
wherein the first and the second printed circuit boards (1, 2) are configured to adopt a stacked position in which they are ready to be electrically connected in order to adopt a stacked assembly position, wherein in the stacked position:
• the second side (1.7) of the first printed circuit board (1) faces the fourth side (2.7) of the second printed circuit board (2) defining a stacking direction S, and,
• the first and the second electrical connection holes (1.5, 2.5) are aligned along the stacking direction S,
**characterized in that**,
the electrical connector (6) comprises a fixing device (3) and a first metal plate (4),
wherein the fixing device (3) has a main axle z extended along the stacking direction S, a retention head (3.1) configured to be placed on the first side (1.6) of the first printed circuit board (1), and a bearing head (3.2) configured to be placed on the third side (2.6) of the second printed circuit board (2), and a rod (3.3) extended in the main axle direction z which connects the retention head (3.1) and the bearing head (3.2),
wherein the first metal plate (4) comprises a first electrical connecting pad (4.1) and a second electrical connecting pad (4.2),
wherein the electrical connector (6) is configured to be rotated in order to the connection assembly (10) adopt the stacked assembly position in which the first and the second electrical tracks (1.1, 2.1) are electrically connected in such a way that in the stacked assembly position:
• the first electrical connecting pad (4.1) contacts the first electrical contact (1.3) of the first printed circuit board (1),
• the second electrical connecting pad (4.2) contacts the second electrical contact (2.3) of the second printed circuit board (2).

2. Connection assembly (10) for stacked printed circuit boards according to claim 1 wherein,
the first side (1.6) of the first printed circuit board (1) comprises a third electric track (1.2) and a third electrical contact (1.4) electrically connected to the third electrical track (1.2),
the third side (2.6) of the second circuit board (2) comprises a fourth electric track (2.2) and a fourth electrical contact (2.4) electrically connected to the fourth electrical track (2.2),
the electrical connector (6) comprises a second metal plate (5) configured to electrically connect the first and the second printed circuit boards (1, 2),
wherein the second metal plate (5) comprises a third electrical connecting pad (5.1) and a fourth electrical connecting pad (5.2),
wherein the electrical connector (6) is configured to be rotated in the stacked assembly position in order to electrically connect the third and the fourth electrical tracks (1.2, 2.2) in such a way that:
• the third electrical connecting pad (5.1) contacts the third electrical contact (1.4) of the first printed circuit board (1), and
• the fourth electrical connecting pad (5.2) contacts the fourth electrical contact (2.4) of the second printed circuit board (2).

3. Connection assembly (10) for stacked printed circuit boards according to claim 2 wherein the first and the third electrical tracks (1.1, 1.2) are electrically connected.

4. Connection assembly (10) for stacked printed circuit boards according to claim 2 or 3 wherein the second and the fourth electrical tracks (2.1, 2.2) are electrically connected.

5. Connection assembly (10) for stacked printed circuit boards according to claim 1 wherein the first printed circuit board (1) comprises a further electrical connection hole and the second printed circuit board (2) comprises a further electrical connection hole, wherein both further electrical connection holes are configured to be aligned in stacking direction S.
